# EUROPEAN PATENT SPECIFICATION

(11) **EP 1 310 998 B1**
(45) Date of publication and mention of the grant of the patent: **09.07.2008**
(21) Application number: 02025514.7
(22) Date of filing: 13.11.2002
(51) Int. Cl.: H01L 27/06, H01L 21/02

(54) **Semiconductor device**
Halbleiterbauelement
Dispositif semi-conducteur

(30) Priority: 13.11.2001 JP 2001347121
(43) Date of publication of application: 14.05.2003
(73) Proprietor: Ricoh Company, Ltd., Tokyo 143-8555 (JP)
(72) Inventor: Shimizu, Akira, Kobe-shi, Hyogo (JP)
(74) Representative: Schwabe - Sandmair - Marx

(56) References cited:
- US-A- 4 391 650
- US-A- 4 609 935
- US-A- 5 382 916
- US-A- 5 825 068
- US-A- 6 069 063
- US-A- 6 100 154
- US-B1- 6 232 194
- PATENT ABSTRACTS OF JAPAN vol. 2000, no. 09, 13 October 2000 (2000-10-13) -& JP 2000 183182 A (NEC CORP), 30 June 2000 (2000-06-30)
- MASAKA<U NAKABAYASHI ET AL: "INFLUENCE OF HYDROGEN ON ELECTRICAL CHARACTERISTICS OF POLY-SI RESISTOR" JAPANESE JOURNAL OF APPLIED PHYSICS, PUBLICATION OFFICE JAPANESE JOURNAL OF APPLIED PHYSICS. TOKYO, JP, vol. 32, no. 9A, PART 1, 1 September 1993 (1993-09-01), pages 3734-3738, XP000487537 ISSN: 0021-4922

## Description

### BACKGROUND OF THE INVENTION

### 1. Field of the Invention

The present invention relates to a semiconductor device, and more specifically to a semiconductor device having a CMOS (complementary metal oxide semiconductor) and polysilicon resistance body. The CMOS includes a p-channel MOS transistor and an n-channel MOS transistor. Such a semiconductor device may be applied to an analog integrated circuit.

### 2. Description of the Related Art

CMOS devices are main elements of a logic semiconductor device. However, an analog semiconductor device includes a polysilicon resistance body having a polysilicon film as well as the CMOS device. Such a structure is known from US 5 825 068. Characteristics required for each device or element of the analog semiconductor device differ largely from those required by the logic semiconductor device. For example, in a case of an analog integrated circuit such as a power management integrated circuit, it is necessary to suppress leak electric current of a MOS transistor in order to decrease consuming current as much as possible. In addition, low on-state resistance and low power operation need to be realized.

In the analog semiconductor device,' threshold voltage control performance, stabilization (or drift) of a threshold voltage of the MOS transistor, resistance value control performance of the polysilicon resistance body, and stabilization (or drift) of the resistance value directly affect output accuracy of an analog circuit such as a differential amplifier circuit and a reference voltage generation circuit. Accordingly, the analog semiconductor device requires comparably higher performance than that of the logic semiconductor device. The control performance includes a degree of deviation from a set value, and includes a degree of the deviation on the surface and a degree of the difference between characteristics of two devices adjacent to each other. The stabilization includes change due to the time lapse, for example, the difference between the threshold voltage or the resistance value before packaging and the threshold voltage or the resistance value after packaging. Further, the stabilization includes the difference between the threshold voltage or the resistance value before environmental testing such as PCBT (pressure cooker bias test) and the threshold voltage or the resistance value after environmental testing.

In a buried channel structure of a p-channel MOS transistor (hereinbelow, referred to as a PMOS), it is difficult to decrease leak current. For this reason, there are many cases in which a surface channel type PMOS (hereinbelow, referred to as a P+polyPMOS) having a gate electrode (hereinbelow, referred to as a P+ poly gate electrode) of a polysilicon film into which p-type impurities have been introduced is used. The most advantageous feature of the P+polyPMOS is it easily realizes both low threshold voltage and low leak current, enabling low power operation of the circuit.

When both the analog circuit and the logic circuit are provided on the same semiconductor substrate, there are many cases where the P+polyPMOS constitutes the analog circuit, and a buried channel PMOS (hereinbelow, referred to as an N+polyPMOS) having a gate electrode (hereinbelow, referred to as N+ poly gate electrode) of a polysilicon film into which n-type impurities have been introduced constitutes the logic circuit. Particularly, the performance of the P+poly PMOS used for the analog circuit tends to be regarded as important.

However, the threshold voltage control performance and the stabilization of the threshold voltage in the P+poly PMOS is more difficult than those in the N+pol PMOS for the following reason. The density of impurities in the polysilicon film which constitutes the P+ poly gate electrode is lower than the density of impurities in the polysilicon film which constitutes the N+ poly gate electrode, and many dangling bonds exist in the P+polyPMOS. As a result, many interface states exist at an interface between a gate oxide film and the P+ poly gate electrode.

On the other hand, it is also necessary to improve threshold voltage control performance and stabilization of the threshold voltage in the n-channel MOS transistor (hereinbelow, referred to as the NMOS).

A TEOS (tetra ethyl ortho silicate) oxide film which conventionally is often used as an insulation film between layers (or inter-layer dielectrics) in a wiring process contains a large amount of hydrogen. A plasma SiN film which conventionally is often used as a passivation protection film also contains a large amount of hydrogen. The contained hydrogen diffuses up into the gate oxide film by a heating process at the time of alloying a metal wiring layer, by a heating process at the time of hardening resin, and by the PCBT testing which is the environmental testing performed after the product is finished. As a result, a trap state is generated in the gate oxide film and at an interface between the polysilicon film and the gate oxide film. Accordingly, the drift of the threshold voltage of the MOS transistor and the tolerance to hot carriers become inferior. Japanese Patent Publication No. 6-163522 discloses a method of improving the threshold voltage control performance of the MOS transistor, the stabilization of the threshold voltage, and the tolerance against the hot carriers. In this method, the MOS transistor is covered with a silicon nitride film. This prior technique prevents the hydrogen from diffusing from the plasma SiN film into the gate oxide film by a blocking effect of the silicon nitride film which blocks the hydrogen.

For example, the polysilicon resistance body including the polysilicon film is used as the resistance that is an element of the circuit. In a case where the polysilicon resistance body is applied to the analog circuit, there is a necessity of realizing high accuracy in the resistance ratio and realizing the high stabilization. This necessity is more than that in a case where the polysilicon resistance body is applied to the logic circuit such as SRAM (static random access memory).

The diffusion of the hydrogen from a TEOS film and the plasma SiN film is considered the cause of accuracy differences in the polysilicon resistance body. Japanese Patent Publication No. 5-56661 proposes a method of improving the accuracy in the resistance ratio of the polysilicon resistance and the stabilization. In this method, the silicon nitride film which blocks the hydrogen is used.

The above-described methods are adopted for the individual devices. However, in order to exhibit a function of the analog semiconductor device, the individual devices need to be placed on the same semiconductor substrate without reducing the functions of the individual devices.

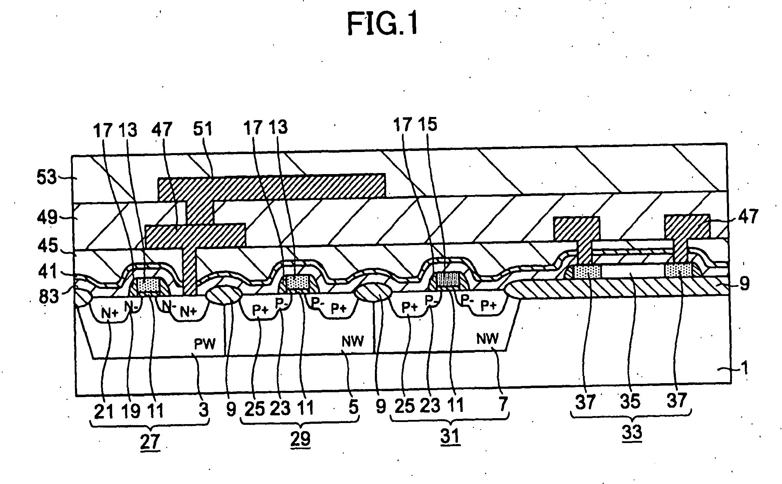

Fig. 1 shows a sectional view of the conventional semiconductor device which includes the analog CMOS having the silicon nitride film for blocking hydrogen.

A p-well region 3 (PW) which includes the p-type impurities is formed on a semiconductor substrate 1. In addition, n-well regions 5 and 7 (NW) which include n-type impurities are formed on the semiconductor substrate 1. The p-well region 3, and the n-well regions 5 and 7 are isolated from each other by device isolation regions 9 which include thick oxide films formed on a surface of the semiconductor substrate 1.

An N+ poly gate electrode 13 is formed on the p-well region 3 and the n-well region 5 such that a gate oxide film 11 is provided between the N+ poly gate electrode 13 and the p-well region 3 and between the N+ poly gate electrode 13 and the n-well region 5. The N+ poly gate electrode 13 includes a polysilicon film into which the n-type impurities are introduced. A P+ poly gate electrode 15 is formed on the n-well region 7 such that a gate oxide film 11 is provided between the P+ poly gate electrode 15 and the n-well region 7. The P+ poly gate electrode 15 includes a polysilicon film into which p-type impurities are introduced.

When the N+ poly gate electrode is formed, the polysilicon film which has not been doped is formed on the entire surface of the semiconductor substrate 1 by a CVD (chemical vapor deposition) method. After that, ion implantation on the polysilicon film which has not been doped is performed by using n-type impurities such as phosphorus, or PH₃ is introduced into the polysilicon film in high density by thermomigration by using gas whose main element is PH₃. The polysilicon film is then patterned and formed in a desired shape by an etching technique.

When the P+ poly gate electrode is formed, the polysilicon film which has not been doped is formed on the entire surface of the semiconductor substrate 1 by the CVD method or the like concurrently with formation of the N+ poly gate electrode 13. After a region into which n-type impurities are introduced in high density is masked with an oxide film formed by the CVD method or with a photoresist, the polysilicon film is patterned in a desired shape by the etching technique. Then, at the same time the ion implantation is performed for forming the source/drain region of the PMOS, the p-type impurities are introduced into the polysilicon film for forming the P+ poly gate electrode 15. Alternatively, before the polysilicon film used for the P+ poly gate electrode 15 is patterned, the p-type impurities are introduced into the polysilicon film by the ion implantation.

A side wall 17 including an oxide film formed by an etch back technique is formed at sides of the gate oxide films 11, the N+ poly gate electrodes 13, and the P+ poly gate electrode 15. A source/drain region of the NMOS is formed on the p-well region 3. Furthermore, N- diffused layer (N-) 19 into which n-type impurities are introduced in low density, and N+ diffused layer (N+) 21 into which the n-type impurities are introduced in high density are formed on the p-well region 3. A source/drain region of the PMOS is formed on the n-well regions 5 and 7. Further, P- diffused layer (P-) 23 into which the p-type impurities are introduced in low density, and P+ diffused layer (P+) 25 into which the p-type impurities are introduced in high density are formed on the n-well regions 5 and 7.

A resistance element 33 is formed on the device isolation region 9. The resistance element 33 includes a polysilicon resistance body 35 and polysilicon films 37 having low resistance. The polysilicon film 37 is formed at both sides of the polysilicon resistance body 35. The polysilicon films 37 are used for electrical connection. The resistance element 33, and the gate electrodes 13 and 15 are formed simultaneously. After the polysilicon film which has not been doped is formed, the n-type impurities are introduced into the polysilicon resistance body 35 by the ion implantation so as to obtain a desired resistance. After that, phosphorus which is the n-type impurities is introduced into the plolysilicon films 37 in high density in a state in which the polysilicon resistance body 35 is masked with the oxide film formed by the CVD method or the like. In order to obtain good electrical connection, the n-type impurities are introduced into the polysilicon films 37 in the same density as the density in which the n-type impurities are introduced into the N+ poly gate electrodes 13.

A CVD oxide film 83 is formed by an atmospheric CVD method so as to cover the MOS transistors and the resistance element 33. A thickness of this oxide film 83 is about 100 to 300 nanometers. In order to maintain a resistance value of the polysilicon resistance body 35 of the resistance element 33, the CVD oxide film 83 is an NSG film which does not contain the impurities, and the thickness of the CVD oxide film 83 needs to be about 100 to 300 nanometers so as to prevent the impurities from diffusing into the MOS transistors and the resistance element 33 from a BPSG (borophos phosilicate glass) film formed above the CVD oxide film in a later process.

A silicon nitride film 41 having a thickness of about 1 to 20 nanometers is formed on the CVD oxide film 83. If the polysilicon nitride film 41 is formed directly on the polysilicon resistance body 35 without interposing the CVD oxide film 83 between the polysilicon nitride film 41 and the polysilicon resisuance body 35, grains of the polysilicon resistance body 35 extraordinarily grow, and the resistance value control performance decreases substantially. Accordingly, the CVD oxide film needs to be formed between the polysilicon resistance body 35 and the silicon nitride film 41. The silicon nitride film 41 blocks hydrogen, a large amount of which is contained in an insulation film such as the TEOS film formed above the silicon nitride film 41 in a later process, and is contained in the plasma SiN film used for the passivation protection film. Furthermore, the silicon nitride film 41 decreases a degree at which the tolerance against the hot carriers of the NMOS declines. As a method of forming the silicon nitride film, there is a reduced pressure CVD method in which the silicon nitride film 41 is formed at a temperature of about 700 degrees centigrade by using gas including SiH₂Cl₂ and NH₃.

A BPSG film 45 which functions as an insulation film between layers is formed on the silicon nitride film 41. A surface of the BPSG film 45 is flattened by a heat process at a temperature of about 800 to 900 degrees centigrade after the BPSG film is formed by the atmospheric CVD method. Contact holes are selectively formed on the CVD oxide film 83, the silicon nitride film 41, and the BPSG film 45 above the NMOSs, the PMOS, and the resistance element 33 in Fig. 1. The contact holes are used for electrical connection. All of the contact holes are not shown in Fig. 1.

A barrier metal such as titanium, and aluminum used as material of a wiring layer are successively accumulated on the BPSG film 45 and in the contact holes by a sputtering method. Such metal films are selectively patterned so as to form first wiring layers 47. In a process of forming the first wiring layers 47, alloying is performed in a hydrogen atmosphere at a temperature of about 420 degrees centigrade after a process of patterning the first wiring layers 47.

A second insulation film 49 functioning as insulation between layers is formed on the BPSG film 45 and the first wiring layers 47. The second insulation film 49 includes the TEOS oxide film formed by the plasma CVD method and a SOG (spin on glass) film formed on the TEOS oxide film for flattening a surface of the second insulation film 49. Through holes are selectively formed on the second insulation film 49 on the first wiring layers 47 for electrically connecting the first wiring layer 47 and a second wiring layer 51. In Fig. 1, all of the through holes are not shown.

Aluminum is accumulated on the second insulation film 49 and in the through holes by the sputtering method, and is then patterned so as to form the second wiring layer 51.

A plasma nitride film 53 functioning as the passivation protection film is formed on the second insulation film 49 and the second wiring layer 51 by the plasma CVD method, for example.

In the above-described conventional method, the silicon nitride film 41 prevents the hydrogen from diffusing into the MOS transistors and the resistance element 33 from the layers provided above the silicon nitride film 41. Accordingly, it is possible to decrease a degree at which the tolerance to the hot carriers of the NMOS transistors declines. In addition, it is possible to improve the resistance value control performance of the polysilicon resistance body 35 included in the resistance element 33.

However, it was found that if the above-described method is applied to the analog devices, the threshold voltage control performance of the MOS transistor, the stabilization of the threshold voltage, and the stabilization of the resistance value of the polysilicon resistance body became inadequate. For this reason, it has been difficult to provide all devices that effectively function in the analog semiconductor device, and some of the device performance has been sacrificed.

It became apparent that the stabilization of the threshold voltage of the NMOS was inadequate as the performance required for the analog device. For example, an input stage of the analog circuit such as the reference voltage circuit and the differential amplifier circuit includes the NMOS, and drift of the threshold voltage causes drift of analog output. The cause of the drift of the threshold voltage at the NMOS is that the oxide film on the gate electrode is formed by the CVD method, and the thickness of the oxide film is large, that is, about 100 to 300 nanometers.

The CVD oxide film is porous and tends to absorb the hydrogen even if a heat process is performed on the CVD oxide film at a temperature equal to or higher than 800 degrees centigrade after the CVD oxide film is formed. Moreover, the greater is the thickness of the CVD oxide film, the more the CVD oxide film absorbs the hydrogen. In the conventional method, a small amount of hydrogen is generated at the time the silicon nitride film is formed on the CVD oxide film. In this case, the CVD oxide film which is porous and thick easily absorbs the hydrogen. Although an amount of the hydrogen that is absorbed in the CVD oxide film is small, the absorbed hydrogen causes the characteristics of the MOS transistor to change at the time of packaging and the environmental testing.

Further, there is another problem, in that in the conventional method in which the entire surface of the semiconductor substrate is covered with the silicon nitride film, the region of the PMOS is also covered with the silicon nitride film, and the threshold voltage control performance is deteriorated.

In a case of the PMOS, if when alloying is performed in the hydrogen atmosphere after the first wiring layer is formed, the trap state which exists at the gate oxide film is not stabilized, the threshold voltage is unstable, and difference in the threshold voltages becomes substantial. Particularly, in the P+ poly PMOS, this tendency is substantial, and it was found that difference in the threshold voltage between a case where the silicon nitride film exists and a case where the silicon nitride film does not exist is 150 mV. In the analog semiconductor device which requires low voltage operation and low current leak, if the P+ poly PMOS whose threshold voltage control performance and stabilization of the threshold voltage are high is not provided in the analog semiconductor device, it is difficult to realize a product that possesses excellent performance.

Japanese Patent Publication No. 2000-183182 proposes a method of removing the silicon nitride film above the region where the PMOS exists in order to obtain high threshold voltage control performance of the PMOS. In this method, it was found that the threshold voltage control performance of the N+poly PMOS and the P+poly PMOS could be improved, and the stabilization of the threshold voltage of the P+poly PMOS was decreased.

Similarly with respect to the case of the NMOS, the cause of decrease in the stabilization of the threshold voltage is that the silicon nitride film is formed on the PMOS once, and is then removed by the etching method. The CVD oxide film, however, absorbs the hydrogen in a process of forming the silicon nitride film, affecting the characteristics of the PMOS.

Particularly, in a case of an analog circuit such as a current limiter control circuit in which a high voltage is applied to the gate electrode for a long period, the stabilization of the threshold voltage is required rather than the threshold voltage control performance. Likewise, in the analog integrated circuit, since important characteristics differ depending on a circuit form, it is necessary to select an optimum device structure.

Furthermore, there is another problem in that it was found that the introduction of the silicon nitride film largely contributed to the resistance control performance of the polysilicon resistance body, but the stress was large, affecting the stabilization of the polysilicon resistance body. Particularly, it was confirmed that when the environmental testing was carried out after the packaging, the drift becomes larger than the conventional case. This is because an amount of the hydrogen connected to the dangling bond changes due to the stress applied by the silicon nitride film. A source of providing the hydrogen is considered to be the hydrogen remaining in the CVD oxide film. Accordingly, in realizing the stabilization of the polysilicon resistance body, it is necessary to improve the oxide film on the polysilicon resistance body, and to relieve the stress applied by the silicon nitride film.

### SUMMARY OF THE INVENTION

With the view of the foregoing, it is important to optimize material and a thickness of the oxide film on the MOS transistor and the polysilicon resistance body, in order to improve characteristics of the analog device into which the silicon nitride film is introduced.

It is an object of the present invention to improve the threshold voltage control performance and the stabilization of the threshold voltage in the PMOS and the NMOS, and to improve the resistance value control performance and the stabilization of the resistance value in the polysilicon resistance body. The PMOS and the NMOS which constitute the CMOS, and the polysilicon resistance body are included in the semiconductor device.

In order to achieve the object, a semiconductor device is disclosed as in claim 1. Further features of the device are disclosed in claims 2-7. With this semiconductor device, the silicon nitride film prevents hydrogen from diffusing into the NMOS and the polysilicon resistance body. Accordingly, it is possible to suppress decrease in tolerance to or against hot carriers of the NMOS, and to improve resistance value control performance of the polysilicon resistance body. Since the silicon nitride film does not exist above the PMOS, threshold voltage control performance of the PMOS is not reduced. In addition, by providing the thermal oxide film as an oxide film under the silicon nitride film, and making the thickness of the thermal oxide film 5 to 80 nanometers, it is possible to improve stabilization of a threshold voltage of the NMOS, and to improve stabilization of a resistance value of the polysilicon resistance body. Furthermore, since the thermal oxide film is formed also on the PMOS, it is possible to improve stabilization of a threshold voltage of the PMOS.

In the present invention, one example of the p-channel MOS transistor may be a surface channel type of a p-channel MOS transistor (P+poly PMOS) that includes a gate electrode having a polysilicon film into which the p-type impurities are introduced. The threshold voltage control performance and the stabilization of the threshold voltage in the P+polyPMOS is largely affected by the hydrogen. Accordingly, an effective result on the PMOS that is achieved by the present invention is particularly advantageous to P+ poly PMOS.

A non-doped oxide film into which impurities have not been introduced is preferably formed on the silicon nitride film above a region where the polysilicon resistance body is formed. The polysilicon resistance body is preferably covered with a metal wiring layer, and an insulation film formed on the non-doped oxide film is provided between the polysilicon resistance body and the metal wiring layer. Preferably, the metal wiring layer includes metal material such as aluminum, and has thickness is at least 400 nanometers. The insulation film may function as insulation between layers.

Hydrogen contained in the insulation layer formed above the polysilicon resistance body affects the resistance value of the polysilicon resistance body, and a blocking effect to the hydrogen achieved by the silicon nitride film is excellent. However, as a side effect of the blocking effect, the stress applied to the polysilicon resistance body by the silicon nitride film affects the stabilization of the resistance value.

By taking this point into consideration, the polysilicon resistance body is preferably covered with the metal wiring layer, and the non-doped oxide film and the insulation film are provided between the polysilicon nitride film and the metal wiring layer.

Furthermore, the non-doped oxide film is preferably provided on the silicon nitride film, so that impurities can be prevented from diffusing into the polysilicon resistance body from the insulation layer formed on the non-doped oxide film.

When the metal wiring layer is a usually-used aluminum wiring layer, the thickness of the metal wiring layer is preferably equal to or more than 400 nanometers. With this thickness, it is possible to effectively relieve the stress applied to the polysilicon resistance body by the silicon nitride film. If only nitride titanium which is used as a barrier metal is used for the metal wiring layer, the stress relieving effect cannot be adequately obtained because the nitride titanium is hard. Further, when the thickness of the metal wiring layer is small, the stress relieving' effect becomes small. The aluminum wiring layer having a thickness that is equal to or more than 400 nanometers is usually used for the CMOS device, and therefore, an additional process for the metal wiring layer is not necessary, so that this metal wiring layer is advantageous when taking manufacturing costs into account.

When high accuracy in the ratio between divided resistances is required, the fact that the layers located above the resistance body are not subtly uniform reduces the accuracy. It is necessary to eliminate the factor of the difference in the resistance values.

For this reason, it is preferable that another metal wiring layer is not formed above the metal wiring layer formed above the polysilicon resistance body. As a result, the resistance value control performance of the polysilicon resistance body can be securely realized.

When the metal wiring layer is not formed above the polysilicon resistance body, the polysilicon resistance body preferably has a resistance value of equal to or less than 3000 Ω /square (i.e., Ω /□), and the non-doped oxide film into which impurities have not been introduced is preferably formed on the silicon nitride film.

By making the sheet resistance value of the polysilicon resistance body equal to or less than 3000 Ω/square (i.e. Ω/□), it is possible to prevent the polysilicon resistance body from being affected by the stress applied by the silicon nitride film. In other words, even if the metal wiring layer for relieving the stress applied to the polysilicon resistance body is not formed above the polysilicon resistance body, it is possible to obtain the polysilicon resistance body whose stabilization of the resistance value is high. In this manner, it is also possible to reduce a capacity generated between the polysilicon resistance body and the metal wiring layer, and to apply this semiconductor device to a circuit system that requires a high speed operation.

The present invention can be applied to an analog integrated circuit which includes a voltage divider for dividing a voltage to be detected, a reference voltage source for providing a reference voltage, and a comparing circuit for comparing a divided voltage provided by the voltage divider with the reference voltage provided by the reference voltage source.

In this analog integrated circuit, the CMOS device constituting any one of the embodiments of the present invention may be applied to at least one of the reference voltage source and the comparing circuit. Since the PMOS and the NMOS constituting any one of the embodiments can improve the threshold voltage control performance and/or the stabilization of the threshold voltage, it is possible to improve accuracy in output from one of or both of the reference voltage source and the comparing circuit, and to improve accuracy in output from the analog integrated circuit.

Furthermore, a polysilicon film constituting any one of the embodiments of the present invention may be applied to the voltage divider. In such a case, it is possible to improve the resistance value control performance and the stabilization of the resistance value, and therefore, to improve accuracy in the divided voltage provided by the voltage divider. Accordingly, accuracy achieved by the analog integrated circuit can be improved.

### BRIEF DESCRIPTION OF THE DRAWINGS

Fig. 1 is a sectional view of a conventional semiconductor device having an analog CMOS which includes a silicon nitride film for blocking hydrogen.
Fig. 2 is a sectional view of a first embodiment of a semiconductor device according to the present invention.
Figs. 3A, 3B, and 3C are sectional views in a process of manufacturing the first embodiment shown in Fig. 1.
Fig. 4A is a graph showing distribution of a threshold voltage of a P+poly PMOS on a wafer surface in the conventional semiconductor device.
Fig. 4B is a graph showing distribution of a threshold voltage of a P+poly PMOS on a wafer surface in the first embodiment shown in Fig. 1.
Fig. 4C is a graph showing distribution of a threshold voltage of a P+poly PMOS on a wafer surface in a third embodiment shown in Fig. 11.
Fig. 5 is a graph showing results of measuring threshold voltage drift of an N+polyPMOS which is caused by material and a thickness of an oxide film on the N+poly PMOS, the solid line indicates the result obtained when a thermal oxide film is used as the oxide film, and the dashed line indicates the result obtained when a CVD oxide film is used as the oxide film.
Fig. 6 is a graph showing results of measurement concerning stabilization of a resistance value of a polysilicon resistance body which is affected by material and a thickness of an oxide film on the polysilicon resistance body, the solid line indicates the result obtained when the thermal oxide film is used as the oxide film, and the dashed line indicates the result obtained when the CVD oxide film is used as the oxide film.
Fig. 7 is a graph showing a result of measurement concerning change in a life span of hot carriers of the N+poly NMOS as related to a thickness of the silicon nitride film.
Fig. 8 is a graph showing a result of measurement concerning change (indicated by the solid line) in a resistance value of the polysilicon resistance body and change in resistance value drift (indicated by the dashed line) of the polysilicon resistance body, as related to the thickness of the silicon nitride film.
Fig. 9 is a sectional view of a second embodiment of the semiconductor device according to the present invention.
Fig. 10 is a graph showing results of measurement concerning resistance value drift of the polysilicon resistance body when a first wiring layer exists above the polysilicon resistance body and when the first wiring layer does not exist above the polysilicon resistance body.
Fig. 11 is a sectional view of a third embodiment of the semiconductor device according to the present invention.
Fig. 12 is a sectional view of a fourth embodiment of the semiconductor device according to the present invention.
Fig. 13 is a circuit diagram showing a constant voltage generation circuit to which any one of the embodiments of the semiconductor device may be applied.
Fig. 14 is a circuit diagram showing a voltage detection circuit to which any one of the embodiments of the semiconductor device may be applied.

### DETAILED DESCRIPTION OF THE PREFERRED EMBODIMENTS

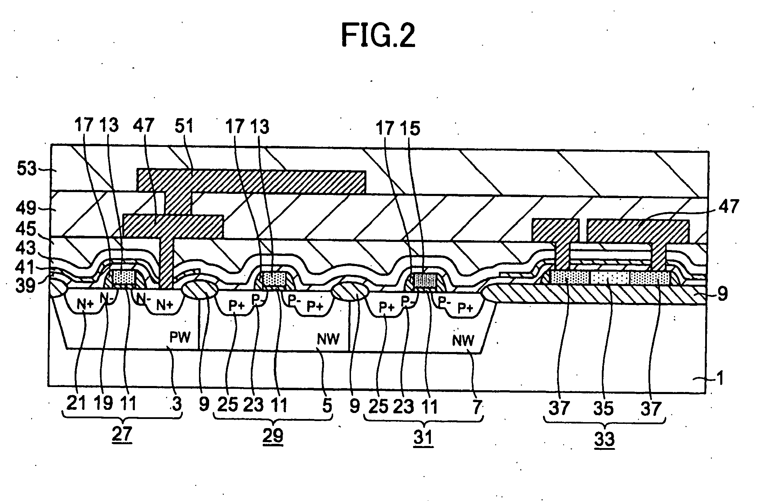

In Fig. 2, a sectional view of a first embodiment of a semiconductor device according to the present invention is shown. A p-well region (PW) 3 into which p-type impurities have been introduced, and n-well regions (NW) 5 and 7 into which n-type impurities have been introduced are formed on a semiconductor substrate 1. The p-well region 3, and the n-well regions 5 and 7 are isolated from each other by a device isolation region 9 that includes a thick oxide film formed on the semiconductor substrate 1.

An N+ poly gate electrode 13 into which the n-type impurities have been introduced is formed above the p-well region 3 and the n-well region 5, and a gate oxide film 11 is provided between the N+ poly gate electrode 13 and the p-well region 3 and between the N+ poly gate electrode 13 and the n-well region 5. A P+ poly gate electrode 15 having a polysilicon film into which p-type impurities are introduced is formed above the n-well region 7, and the gate oxide film 11 is provided between the P+ poly gate electrode 15 and the n-well region 7.

Thicknesses of the N+ poly gate electrodes 13 and the P+ poly gate electrode 15 are about 400 nanometers, for example. A side wall 17 is formed at sides of the gate oxide films 11, the N+ poly gate electrodes 13, and the P+ poly gate electrode 15.

A source/drain region of the NMOS is formed at the p-well region 3 so as to sandwich the N+ poly gate electrode 13. Two N- diffused layers (N-) 19 into which n-type impurities are introduced in low density are formed on the p-well region 3 with an interval being provided between the N- diffused layers 19. As shown in Fig. 2, two N+ diffused layers (N+) 21 into which the n-type impurities are introduced in high density are formed such that the distance between the N+ diffused layers 21 and the N+ poly gate electrode 13 is greater than that between the N- diffused layers 19 and the N+ poly gate electrode 13.

At the p-well region 3, the gate oxide film 11, the N+ poly gate electrode 13, the N- diffused layers 19, and the N+ diffused layers 21 constitute an N+ poly NMOS 27.

A source/drain region of a PMOS is formed on the n-well region 5 so as to sandwich the N+ poly gate electrode 13. Two P- diffused layers (P-) 23 into which p-type impurities have been introduced in low density are formed on the n-well region 5 with an interval being provided between the P- diffused layers 23. Two P+ diffused layers (P+) 25 into which p-type impurities have been introduced in high density are formed such that the distance between the P+ diffused layers 25 and the N+ poly gate electrode 13 is greater than that between the P- diffused layers 23 and the N+ poly gate electrode 13.

At the n-well region 5, the gate oxide film 11, N+ poly gate electrode 13, the P- diffused layers 23, and the P+ diffused layers 25 constitute a buried channel type of p-channel MOS transistor (herein below, referred to as N+poly PMOS) 29.

A source/drain region of the PMOS is formed on the n-well region 7 so as so sandwich the P+ poly gate electrode 15. Two P- diffused regions (P-) 23 into which the p-type impurities have been introduced in low density are formed on the n-well region 7 with an interval being provided between the P- diffused layers 23. As shown in Fig. 2, two P+ diffused layers (P+) 25 into which the p-type impurities have been introduced in high density are formed such that the distance between the P+ diffused layers 25 and the P+ poly gate electrode 15 is greater than that between the P- diffused layers 23 and the P+ poly gate electrode 15.

At the n-well region 7, the gate oxide film 11, the P+ poly gate electrode 15, the P- diffused layers 23, and the P+ diffused layers 25 constitute a P+poly PMOS 31.

A resistance element 33 including a polysilicon film is formed on a device isolation region 9. The resistance element 33 includes a polysilicon resistance body 35. For example, the n-type impurities are introduced into the polisilicon resistance body 35 in appropriate density so as to determine a resistance value. The resistance element 33 further includes polisilicon films 37 that have low resistance and that are used for electrical connection. The n-type impurities are introduced into the polisilicon films 37 in high density, for example. The polisilicon film 37 is formed at both sides of the polysilicon resistance body 35.

As one example, a thermal oxide film 39 having a thickness of about 5 to 80 nanometers is formed on the N+ poly NMOS 27, the N+ poly PMOS 29, the P+ poly PMOS 31, and the resistance element 33.

A silicon nitride film 41 having a thickness of about 5 to 30 nanometers is formed on the thermal oxide film 39 above a region including a region where the N+poly NMOS 27 and the resistance element 33 are formed but excluding a region where the N+polyPMOS 29 and the P+poly PMOS 31 are formed.

An NSG film 43 having a thickness of about 300 nanometers is, as one example, formed on the thermal oxide film 39 and the silicon nitride film 41. A BPSG film 45 is formed on the NSG film 43. A surface of the BPSG film 45 is processed to be flattened. The NSG film 43 and the BPSG film 45 function as an insulation film.

Contact holes for electrical connection are selectively formed on insulation films above the N+ poly gate electrodes 13, the P+ poly gate electrode 15, the N+ diffused layers 21, and the P+ diffused layers 25. In Fig. 2, all of the contact holes are not shown.

A first wiring layer 47 is formed on the BPSG film 45 and in the contact holes. A part of the first wiring layer 47 is formed so as to cover a region above the polysilicon resistance body 35. It is not preferable that the first wiring layer 47 which is not electrically connected floats in the semiconductor device. For this reason, the first wiring layer 47 disposed above the polysilicon resistance body 35 is electrically connected to the polysilicon film 37 having a low resistance value. For example, the first wiring layer 47 includes a barrier metal such as, titanium having a thickness of about 40 nanometers, includes an aluminum alloy containing copper or the like and having a thickness of at least 400 nanometers on the barrier metal, and includes a nitride titanium having a thickness of about 30 nanometers on the aluminum alloy, to form a laminated metal film.

A TEOS film is formed on the BPSG film 45 and the first wiring layer 47, and an SOG film is formed on the TEOS film. The TEOS film and the SOG film constitute a second insulation film 49 which functions as insulation between layers. Through holes electrically connecting the first wiring layer 47 to a second wiring layer 51 are selectively formed on the second insulation film 49. All of the through holes are not shown in Fig. 2.

The second wiring layer 51 having a thickness of about 900 nanometers and including an aluminum alloy containing copper or the like is formed on the second insulation film 49 and in the through holes. The second wiring layer 51 is not formed at a region above the polysilicon resistance body 35. In one example, a plasma SiN film 53 as a passivation protection film is formed on the second insulation film 49 and the second wiring layer 51. The plasma SiN film 53 has a thickness of about 1000 nanometers, for example.

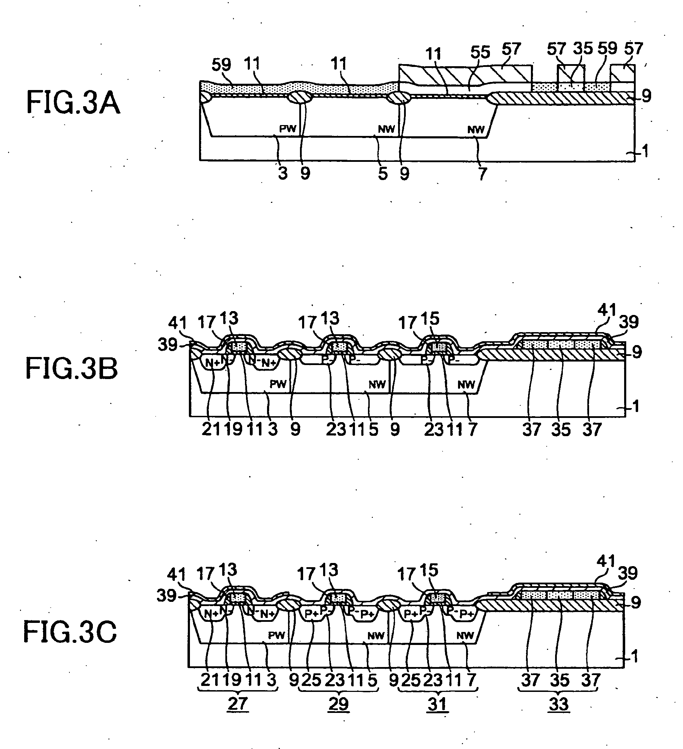

Figs. 3A to 3C are sectional views of the semiconductor device in a process of manufacturing the semiconductor device according to the first embodiment of the present invention. This example of the manufacturing method will be described with reference to Figs. 2, and 3A to 3C.

As shown in Fig. 3A, on the semiconductor substrate 1, the p-well region 3 is formed at a region where the N+poly NMOS is formed, the n-well region 5 is formed at a region where the N+poly PMOS is formed, and the n-well region 7 is formed at a region where the P+poly PMOS is formed. Thereafter, the device isolation region 9 having a thick oxide film is formed on the surface of the semiconductor substrate 1 by a known LOCOS (local oxidation of silicon) method.

Next, the gate oxide films 11 are respectively formed on surfaces of the p-well region 3, and the n-well regions 5 and 7. The gate oxide films 11 have thicknesses of about 15 nanometers in this example. A polysilicon film 55 which has not been doped is then formed on the entire surface of the semiconductor substrate 1 by the reduced pressure CVD method. This polysilicon film 55 has a thickness of about 400 nanometers, and later constitutes a gate electrode and a resistance element.

By an ion implantation method, impurities for controlling a resistance value are introduced at a region where the polysilicon resistance body 35 constituting the resistance element 33 is formed. When the resistance value of the resistance body 35 is adjusted to 10 k Ω /square (i.e., 10 k Ω /□) by introducing phosphorus which is the n-type impurities, an amount of about 3.0 × 10¹⁴ to 6.0 × 10¹⁴/cm² of phosphorus needs to be introduced by the ion implantation. When the resistance value of the resistance body 35 is adjusted to 2 kΩ/square (i.e., 2 kΩ/□) by introducing phosphorus which is the n-type impurities, an amount of about 1.0 × 10¹⁵. to 1.5 × 10¹⁵/cm² of phosphorus needs to be introduced by the ion implantation. Alternatively, the polysilicon resistance body 35 may be realized by using the polysilicon film into which the p-type impurities have been introduced, and boron may be introduced as the p-type impurities.

Then, a CVD oxide film 57 or the like is formed so as to cover at least the polysilicon resistance body 35 and the non-doped polysilicon film 55 at a region where the P+ poly gate electrode for the P+poly PMOS is formed. For example, the CVD oxide film 57 may be formed at a temperature of about 900 degrees centigrade by the CVD method. The polysilicon film 59 having a low resistance value is formed by introducing the n-type impurities such as phosphorus into the non-doped polysilicon film 55 in high density with the CVD oxide film 57 being used as a mask. In this example, the phosphorus is introduced by the thermal diffusion method with PH₃ being used as gas. However, the impurities introducing method for forming the polysilicon film 59 having the low resistance value is not limited to this example, and the impurities may be introduced by the ion implantation with a photoresist pattern being used as a mask.

As shown in Fig. 3B, after the CVD oxide film 57 that absorbed the phosphorus is removed, the p-type impurities are selectively introduced in high density at a region where the P+ poly gate electrode for the P+poly MOS is formed, by the ion implantation method and by using the photoresist. The p-type impurities introduction into the polysilicon film for the P+ poly gate electrode may be performed at the same time p-type impurities introduction which will be described later is performed for forming the P+ diffused layers. In this case, since a process of photolithography can be omitted, manufacturing costs can be reduced.

The polysilicon film which is for the P+ poly gate electrode and into which the p-type impurities have been introduced, the polysilicon resistance body 35, and the polysilicon film 59 having the low resistance value are patterned by etching to form desired shapes. Then, the N+ poly gate electrodes 13, the P+ poly gate electrode 15, the polysilicon resistance body, and the polysilicon film 37 having the low resistance value are formed.

By the ion implantation method, the n-type impurities are introduced to or against the N+ poly gate electrode so as to introduce the n-type impurities into the N- diffused layers of the N+poly NMOS at the p-well region 3, in a self-alignment manner. The p-type impurities are introduced to or against the N+ poly gate electrode 13 so as to introduce the p-type impurities into the P- diffused layers of the N+poly PMOS at the n-well region 5, by the ion implantation manner, in the self-alignment manner. Furthermore, the p-type impurities are introduced to or against the P+ poly gate electrode 15 so as to introduce the p-type impurities into the P- diffused layers of the P+polyPMOS at the n-well region 7, by the ion implantation, in the self-alignment manner. After that, a heat process is performed to activate the impurities, thereby forming the N- diffused layers and the P- diffused layers.

The side wall 17 which includes the CVD oxide film is formed at sides of the gate electrodes 13 and 15, and the gate oxide film 11 by the CVD method and an etch back technique. Then, the n-type impurities such as arsenic in high density are introduced to or against the N+ poly gate electrode so as to introduce the n-type impurities into the N+ diffused layers of the N+poly NMOS, by the ion implantation, in the self-alignment manner. In this manner, the N+ diffused layers 21 are formed.

Concurrently with activation of the n-type impurities which have been introduced into the N+ diffused layers 21, the thermal oxide film 39 is formed in a dried oxidation atmosphere so as to cover the resistance element 33, the N+poly NMOS 27, the N+poly PMOS 29, and the P+poly PMOS 31. This formed thermal oxide film has a thickness of about 5 to 80 nanometers. It should be noted that the thermal oxide film 39 is a dense thermal oxide film, and is not a porous oxide film that is formed by the CVD method or the like. The oxidation atmosphere is preferably the dried oxidation atmosphere that does not include vapor because it was confirmed that if the wet oxidation atmosphere including vapor is used, reduction in the tolerance against the hot carriers of the NMOS was promoted.

The silicon nitride film 41 for blocking the hydrogen is then formed on the entire surface of the silicon substrate 1. A thickness of the silicon nitride film 41 is 5 to 30 nanometers, for example. The thickness of the silicon nitride film 41 contributes to prevention of the reduction in the tolerance to the hot carriers of the N+poly NMOS 27, and improvement in the resistance value control performance and the stabilization of the resistance value in the polysilicon resistance body 35. When the thickness of the silicon nitride film 41 is too thin, capability of blocking the hydrogen is reduced, and when the thickness of the silicon nitride film 41 is too thick, the stabilization of the resistance value in the polysilicon resistance body 35 is decreased due to increase in the stress. As a method of forming the silicon nitride film, there is the reduced pressure CVD method at a temperature of about 700 degrees centigrade in which SiH₂Cl₂ and NH₃, for example, are used as gas. For example, if the silicon nitride film is formed by the plasma CVD method at a temperature of about 400 degrees centigrade, since the formed silicon nitride film contains a large amount of hydrogen, the threshold voltage control performance, the resistance value control performance, and the stabilization of the resistance value cannot be secured.

As shown in Fig. 3C, the silicon nitride film is selectively removed at the regions above the N+poly PMOS 29 and the P+poly PMOS 31, by the etching technique and by using a photoresist pattern having an opening at the regions above the N+poly PMOS 29 and the P+poly PMOS 31. Subsequently, the p-type impurities such as boron are introduced in high density into the region where the P+ diffused layers 25 are formed, by the ion implantation method and by using this photoresist pattern as a mask. Thereby, the P+ diffused layers 25 are formed. In this manufacturing method, the photoresist pattern used for selectively removing the silicon nitride film 41 above the PMOSs 29 and 31 is the same as the photoresist pattern used when the P+ diffused layers 25 are formed. Accordingly, manufacturing costs can be effectively reduced.

The p-type impurities introduction for forming the P+ diffused layers 25 may be performed concurrently with the impurities introduction into the P+ poly gate electrode 15. In this case, the formed thermal oxide film 39 preferably has a thickness of about 5 to 25 nanometers. With this thickness, it is possible to suppress an accelerating potential at the time of the ion implantation for forming the P+ poly gate electrode 15 and the P+ diffused layers 25.

After the photoresist pattern is removed, as shown in Fig. 2, the NSG film 43 is formed on the silicon nitride film 41 and the thermal oxide film 39 so as to have a thickness of about 300 nanometers. In addition, the BPSG film 45 is formed on the NSG film 45 so as to have a thickness of about 500 nanometers. After that, a heat process is performed at a temperature of 800 to 900 degrees centigrade to flatten the BPSG film 45. Furthermore, in order to improve the flatness, the SOG film may be coated on the BPSG film 45.

A contact hole for electrical connection is selectively formed on the insulation film above the N+ poly gate electrodes 13, the P+ poly gate electrode 15, the N+ diffused layers 21, the P+ diffused layers 25, and the polysilicon film 37 having the low resistance value. A barrier metal such as titanium having a thickness of about 40 nanometers is formed on the BPSG film 45 and in the contact hole. The aluminum alloy containing Cu having a thickness of at least 400 nanometers is formed on the barrier metal. A nitride titanium is formed on the aluminum alloy. These metal films may be formed by the sputtering method. The first wiring layer 47 is formed by patterning these metal films.

After the first wiring layer 47 is formed, alloying is performed in a hydrogen atmosphere at a temperature of about 420 degrees centigrade. At the time of this alloying, the silicon nitride film can prevent the hydrogen from diffusing into the N+poly NMOS 27 and the resistance element 33. Accordingly, it is possible to prevent reduction in the tolerance to or against the hot carriers of the N+poly NMOS 27, and to prevent decrease in the resistance value control performance and the stabilization of the resistance value in the polysilicon resistance body 35.

A part of the first wiring layer 47 is disposed so as to cover the region above the entire polysilicon resistance body 35 of the resistance element 33. Since this part of the first wiring layer 47 is formed to relieve the stress applied to the polysilicon resistance body 35 by the silicon nitride film 41, a certain degree of thickness is necessary. For example, the thickness of the first wiring layer is preferably equal to or more than 400 nanometers. The silicon nitride film 41 causes stress fluctuation to sensitively affect the polysilicon resistance body 35, but due to existence of the first wiring layer 47 above the polysilicon resistance body 35, the stabilization of the resistance value in the polysilicon resistance body 35 can be secured.

The TEOS film is formed on the BPSG film 45 and the first wiring layer 47 by the plasma CVD method, for example, and the formed TEOS film is flattened by the SOG film to form the second insulation film 49. The through hole is selectively formed on the second insulation film 49 on the first wiring layer 47. After that, the aluminum alloy containing copper is selectively formed on the second insulation layer 49 and in the through hole by the sputtering method so as to have the thickness of about 900 nanometers, and thereby, the second wiring layer 51 is selectively formed by the etching technique. Preferably, the second wiring layer 51 is arranged such that the second wiring layer 51 does not exist above the polysilicon resistance body 35. If the second wiring layer 51 is arranged above the polysilicon resistance body 35, the resistance value control performance is decreased by a certain degree.

Finally, as shown in Fig. 2, the plasma SiN film 53 is formed as the passivation protection film by the plasma CVD method. The formed plasma SiN film 53 has the thickness of about 1000 nanometers. When the plasma SiN film 53 is formed, the silicon nitride film 41 can prevent the hydrogen from diffusing into the N+poly NMOS 27 and the resistance element 33, so that it is possible to prevent the reduction in the tolerance against or to the hot carriers of the N+polyNMOS 27, and to prevent the decrease in the resistance value control performance and the stabilization of the resistance value in the polysilicon resistance body 35.

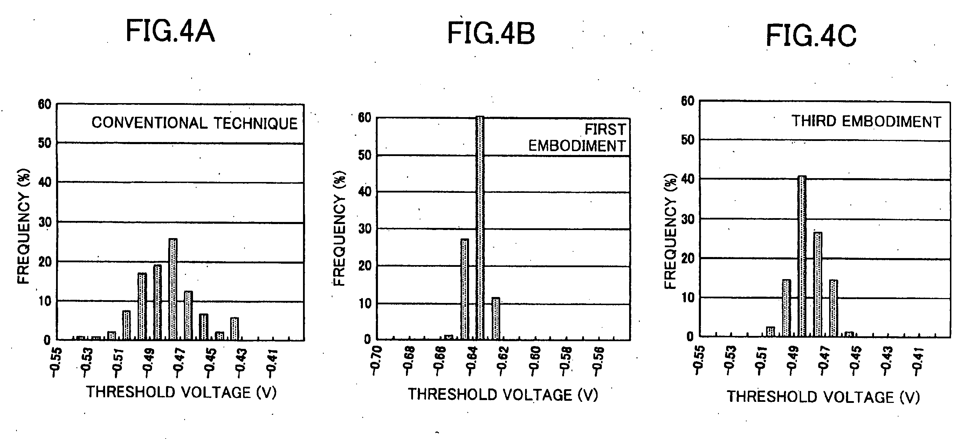

In a device structure of the first embodiment of the semiconductor device according to the present invention, importance is placed on the threshold voltage control performance of the P+poly PMOS. Figs. 4A, 4B, and 4C show distributions of the threshold voltage of the P+poly PMOS on the wafer surface. Fig. 4A shows the distribution in the conventional semiconductor device, Fig. 4B shows the distribution in the first embodiment of the semiconductor device according to the present invention, and Fig. 4C shows the distribution in a third embodiment of the semiconductor device according to the present invention. In these figures, horizontal axes indicate the threshold voltage (V), and vertical axes indicate frequencies (%). In the first and third embodiments, the oxide films on the P+poly PMOS are the thermal oxide films having thicknesses of 25 nanometers. In the conventional technique, the oxide film on the P+poly PMOS is the CVD oxide film having a thickness of 150 nanometers. In the conventional device and the third embodiment, the silicon nitride film having a thickness of 10 nanometers is formed on the CVD oxide film or the thermal oxide film above the P+poly PMOS.

Compared with the conventional semiconductor device shown in Fig. 4A, the distribution of the threshold voltage of the P+poly PMOS on the wafer surface is reduced in the first embodiment shown in Fig. 4B. Accordingly, it is understood from Figs. 4A and 4B that the threshold voltage control performance of the P+poly PMOS is improved.

In the first embodiment, the thickness of the thermal oxide film largely and particularly affects the stabilization of the threshold voltage of the -N+poly NMOS 27 and the stabilization of the resistance value in the polysilicon resistance body 35 of the resistance element 33. If the silicon nitride film 41 is formed directly on the polysilicon resistance body 35 without placing the thermal oxide film 39 on the polysilicon resistance body 35, the grains of the polysilicon resistance body 35 grow extraordinarily when the silicon nitride film 41 is formed. As a result of this, the resistance value control performance in the polysilicon resistance body 35 decreases substantially.

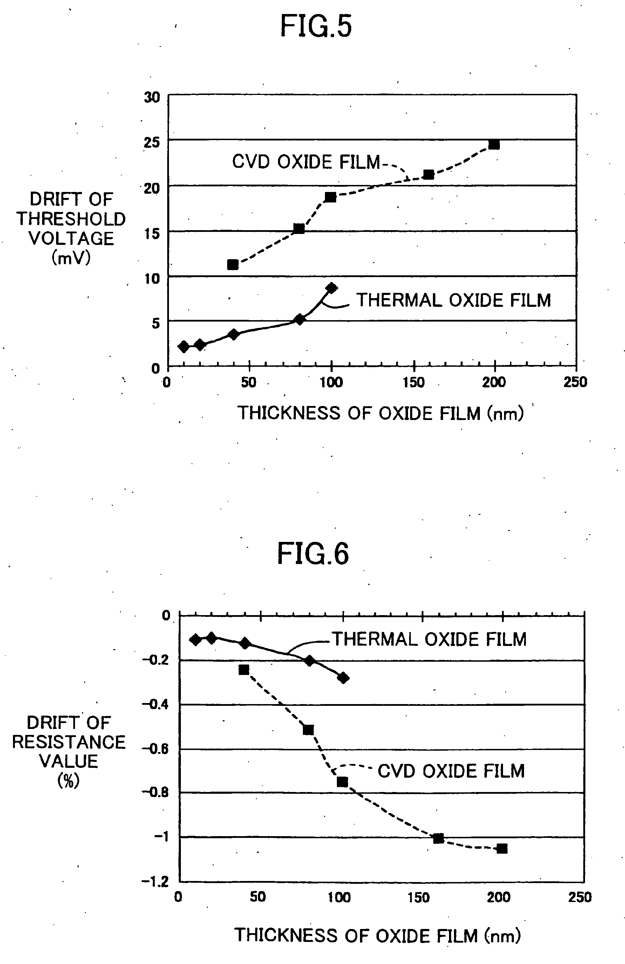

Fig. 5 shows results regarding measurement of drift of the threshold voltage of the N+polyNMOS. This drift is caused by the thickness and material of the oxide film on the N+poly NMOS. In Fig. 5, the solid line indicates the result of the measurement in the first embodiment where the thermal oxide film is used. In Fig. 5, the dashed line indicates the result of the measurement in the conventional semiconductor device where the CVD oxide film is used. In this figure, a horizontal axis indicates a thickness (nanometers) of the oxide film on the N+poly NMOS, and a vertical axis indicates the drift (mV) of the threshold voltage.

Compared to the dashed line corresponding to the CVD oxide film, the drift of the threshold voltage indicated by the solid line corresponding to the thermal oxide film is smaller. Accordingly, with the thermal oxide film, it is possible to improve the stabilization of the threshold voltage of the N+poly NMOS. Particularly, with the thickness of the thermal oxide film being 5 to 80 nanometers, it is possible to realize a drift amount that is equal to or less than 5 mV.

Fig. 6 shows results of measurement regarding the stabilization of the resistance value of the polysilicon resistance body 35. This stabilization of the resistance value is caused by the thickness and material of the oxide film on the polysilicon resistance body 35. In Fig. 6, the solid line indicates the thermal oxide film of the first embodiment, and the dashed line indicates the CVD oxide film of the conventional semiconductor device. In this figure, a horizontal axis indicates the thickness (nanometers) of the oxide film on the polysilicon resistance body 35, and a vertical axis indicates drift (%) of the resistance value of the polysilicon resistance body 35.

A drift amount of the resistance value indicated by the solid line corresponding to the thermal oxide film is smaller than that indicated by the dashed line corresponding to the CVD oxide film. Accordingly, with the thermal oxide film, it is possible to improve the stabilization of the resistance value in the polysilicon resistance body 35. Particularly, with the thickness of the thermal oxide film being 5 to 80 nanometers, it is possible to realize the drift amount that is equal to or less than 0.2 %.

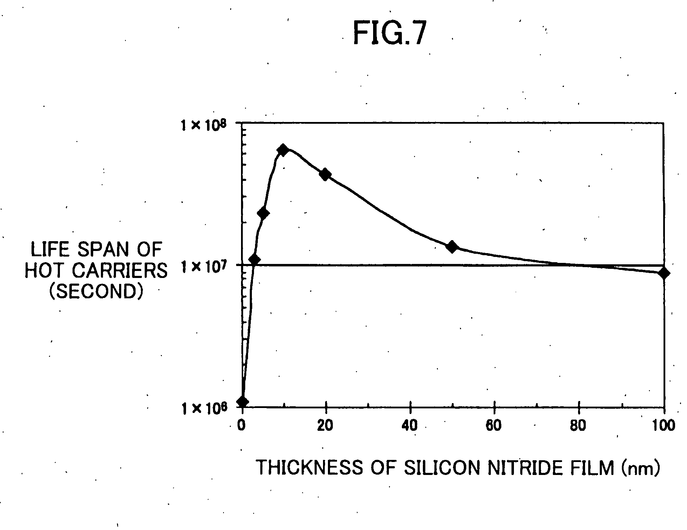

Fig. 7 shows a result of measurement regarding a life span of the hot carriers of N+poly NMOS as related to the thickness of the silicon nitride film. In Fig. 7, a horizontal axis indicates the thickness (nanometers) of the silicon nitride film, and a vertical axis indicates the life span (second) of the hot carriers. In this example, the thermal oxide film having a thickness of 25 nanometers is used as the oxide film between the N+poly NMOS and the silicon nitride film.

The life span of the hot carriers of the N+poly NMOS takes the maximum value at which the silicon nitride film has a thickness of 10 nanometers.

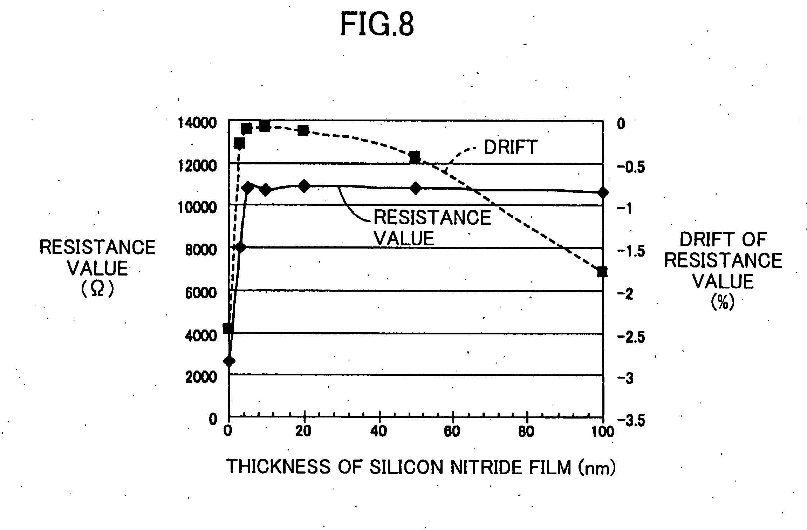

Fig. 8 shows results of measurement regarding a variation (indicated by the solid line) of the resistance value and regarding a drift variation of the polysilicon resistance body 35 as related to the thickness of the silicon nitride film. In Fig. 8, a horizontal axis indicates the thickness of the silicon nitride film, a left vertical axis indicates the resistance value (Q) of the polisilicon resistance body 35, and a right vertical axis indicates the drift (%) of the resistance value. The thermal oxide film having the thickness of 25 nanometers is used as the oxide film between the polysilicon resistance body 35 and the silicon nitride film 41.

As understood from Fig. 8, the resistance value indicated by the solid line drops within a range in which the thickness of the silicon nitride film is less than 3 nanometers. The drift of the resistance value becomes larger than 0.2 % within a range in which the thickness of the silicon nitride film is larger than 30 nanometers.

From the results of Figs. 7 and 8, it has been found that the thickness of the silicon nitride film is preferably 5 to 30 nanometers.

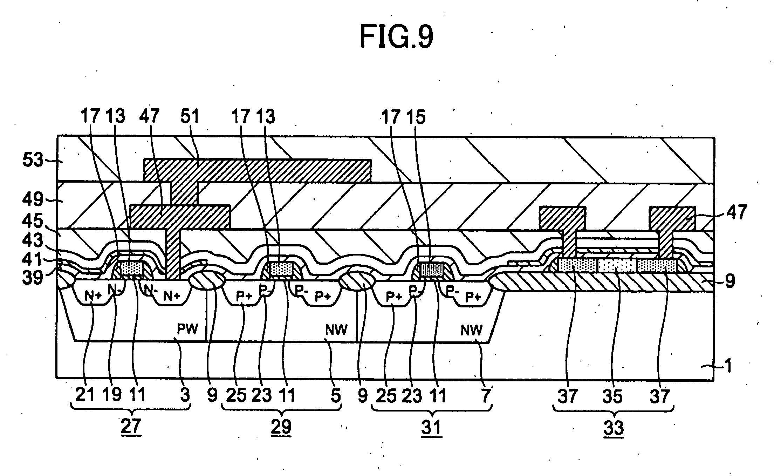

Fig. 9 shows a second embodiment of the semiconductor device according to the present invention. In Fig. 9, the same reference numbers are attached to the same parts as those of Fig. 2, and the overlapping description will be omitted.

The semiconductor device shown in Fig. 9 differs from that shown in Fig. 2 in that the first wiring layer 47 does not cover the region above the polysilicon resistance body 35 of the resistance element 33 in the semiconductor device of Fig. 9.

Such a resistance element 33 shown in Fig. 9 may be used in a feedback system of an analog circuit, and has an advantage when a high speed capability is required. When the first wiring layer 47 is disposed so as to cover the region above the polysilicon resistance body 35, a large parasitic capacity is generated between the polysilicon resistance body 35 and the first wiring layer 47, and high speed performance in a circuit operation may decrease. Accordingly, when the high speed performance is taken into consideration, the first wiring layer 47 cannot be disposed above the polysilicon resistance body 35, and the effect achieved only by the thickness and the material of the thermal oxide film 39 can be expected.

However, the inventor of the present invention discovered that the stabilization of the resistance value largely depended on an initially set resistance value.

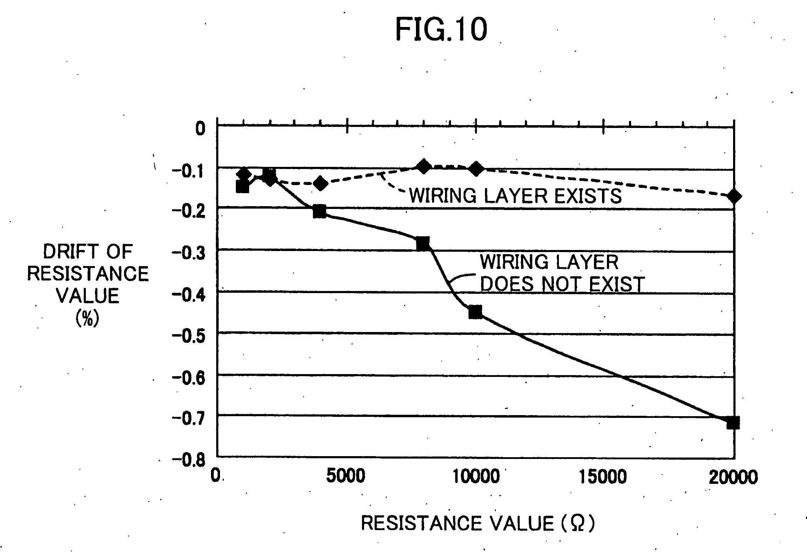

Fig. 10 shows results of measurement regarding a drift variation as related to the resistance value of the polysilicon resistance body 35 in both a case where the first wiring layer 47 exists above the polysilicon resistance body and a case where the first wiring layer 47 does not exist above the polysilicon resistance body. In Fig. 10, the solid line indicates the case where the first wiring layer 47 does not exist above the polysilicon resistance body, and the dashed line indicates the case where the first wiring layer 47 exists above the polysilicon resistance body. In this figure; a horizontal axis indicates the resistance value (Ω /square), and a vertical axis indicates drift (%) of the resistance value.

Even in the case where the fisrt wiring layer 47 does not cover the region above the polysilicon resistance body 35, if the resistance value of the polysilicon resistance body is set to be equal to or less than 3000 Ω/square (Ω/□), it is possible to obtain the stabilization of the resistance value that is substantially equal to the stabilization achieved in the case where the first wiring layer 47 covers the region above the polysilicon resistance body 35.

Meanwhile, in the case where the first wiring layer 47 covers the region above the polysilicon resistance body 35, it is possible to relieve the stress caused by the silicon nitride film 41, and to suppress the drift of the resistance value up to the resistance value of 20 kΩ, as indicated by the dashed line.

In the second embodiment shown in Fig. 9, it is preferable that not only the first wiring layer but also all wiring layers do not exist above the polysilicon resistance body 35. This is because the existence of the wiring layer above the polysilicon resistance body 35 causes the high speed performance to decrease.

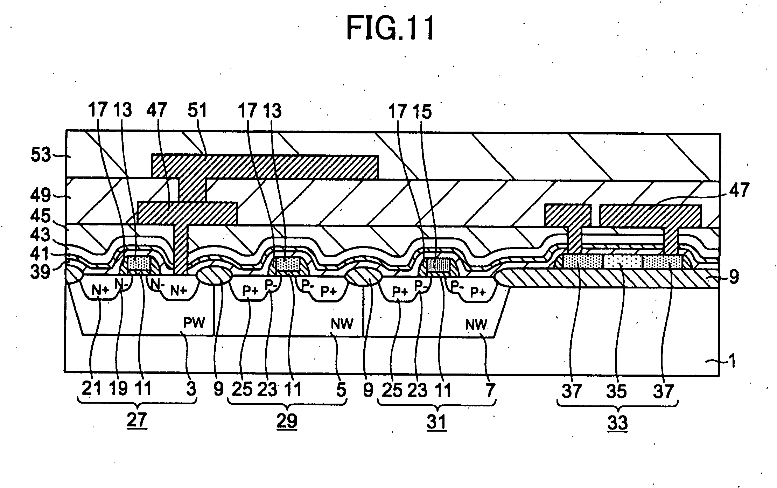

Fig. 11 shows a third embodiment of the semiconductor device according to the present invention. In Fig. 11, the same reference numbers are attached to the same parts as those of Fig. 2, and the overlapping description will be omitted.

The third embodiment differs from the first embodiment shown in Fig. 2 in that the region above the N+poly PMOS 29 and the P+poly PMOS 31 are covered with the silicon nitride film 41 in the third embodiment.

In a case of an analog circuit in which a high voltage is applied to a gate electrode for a long period, suppression of drift of the threshold voltage caused by a slow trap or the like has priority higher than that of the control performance. The slow trap means a trap which is positively charged at a negative bias voltage in a BT process (Bias-Temperature process). The slow trap is considered to be a main factor of causing drift of the threshold voltage of the PMOS. The slow trap is caused by change in Si-O coupling at a Si-SiO₂ interface, and is largely affected by the hydrogen.

In the third embodiment, since the silicon nitride film 41 is formed above the N+poly PMOS 29 and the P+polyPMOS 31, it is possible to suppress the drift of threshold voltage of the N+poly PMOS 29 and the P+poly PMOS 31. This drift of the threshold voltage is caused by the hydrogen. For example, in the first embodiment of Fig. 2 in which the silicon nitride film does not exist above the P+poly PMOS 31, the amount of the drift of the threshold voltage of the P+poly PMOS was 15 mV measured by an experiment. On the other hand, in the third embodiment of Fig. 11 in which the silicon nitride film 41 exists above the P+poly PMOS 31, the amount of the drift of the threshold voltage of the P+poly PMOS was 4 mV measured by an experiment. Accordingly, the third embodiment can be advantageously applied to an analog circuit in which the stabilization of the threshold voltage is considered important.

Fig. 4C shows the distribution of the threshold voltage of the P+poly PMOS on the wafer surface in the third embodiment. The threshold voltage control performance shown in Fig. 4C corresponding to the third embodiment is inferior to that shown in Fig. 4B corresponding to the first embodiment, by some degree. However, compared with the threshold voltage control performance shown in Fig. 4A corresponding to the conventional semiconductor device, the threshold voltage control performance shown in Fig. 4C is improved. This is because the thermal oxide film 39 is formed on the N+polyPMOS 29 and the P+poly PMOS 31. With the third embodiment, it is possible to improve the threshold voltage control performance that has caused the problem in the conventional technique, and to realize characteristics that can adequately stand practical use.

A manufacturing process in the third embodiment differs from the manufacturing process in the first embodiment of Fig. 2 in that a process of selectively removing the silicon nitride film is not carried out in the third embodiment. However, the threshold voltage in the third embodiment is sifted by 150 mV from the threshold voltage in the first embodiment. Accordingly, in order to obtain the same threshold voltage of the N+poly PMOS 29 and the P+poly PMOS 31 as that of the first embodiment, it is necessary to adjust the density of the impurities in the n-well regions 5 and 7 in the third embodiment.

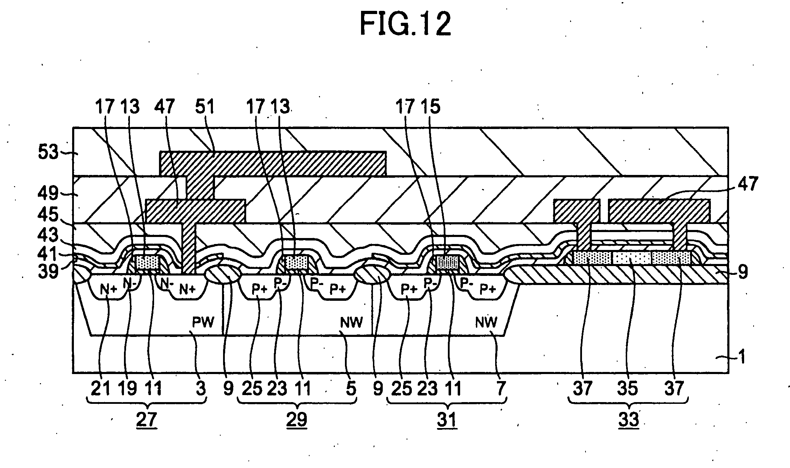

Fig. 12 shows a fourth embodiment of the semiconductor device according to the present invention. In Fig. 12, the same reference numbers are attached to the same parts as those of Fig. 2, and the overlapping description will be omitted.

The fourth embodiment differs from the first embodiment in that the silicon nitride film 41 is formed above the P+poly PMOS 31 in the fourth embodiment. It should be noted that in the third embodiment of the present invention, the P+polyPMOS 31 above which the silicon nitride film 41 is formed, and the N+poly PMOS 29 above which the silicon nitride film is not formed may exist together.

According to the fourth embodiment, it is possible to provide an appropriate device to each of a circuit system that requires the threshold voltage control performance and a circuit system that requires the stabilization of the threshold voltage. However, in a process of manufacturing the fourth embodiment of the semiconductor device, the same photoresist pattern used for selectively removing the silicon nitride film cannot be used at the time of forming the P+ diffused layers 25. Accordingly, another photoresist pattern different from the photoresist pattern used for selectively removing the silicon nitride film needs to be prepared for usage when the P+ diffused layers 25 are formed. Furthermore, in the fourth embodiment, since the region above the P+poly PMOS 31 is covered with the silicon nitride film 41, it is necessary to adjust density of the impurities introduced into the n-well region 7 in order to obtain the same threshold voltage as that of the P+poly PMOS 31 of the first embodiment.

In the fourth embodiment, the silicon nitride film 41 is formed above the P+polyPMOS 31, but is not formed above the N+poly PMOS 29. However, the fourth embodiment is not limited to this structure, and the silicon nitride film 41 need not be formed above the P+poly PMOS 31, but may be formed above the N+poly PMOS 29. Furthermore, in the fourth embodiment, the N+poly PMOS 29 above which the silicon nitride film 41 is formed, and the N+poly PMOS 29 above which the silicon nitride film 41 is not formed may exist together. Likewise, in the fourth embodiment, the P+poly PMOS 31 above which the silicon nitride film 41 is formed, and the P+poly PMOS 31 above which the silicon nitride film 41 is not formed may exist together.

In the first through fourth embodiments, the quantity of the wiring layers is two, but the present invention is not limited to this quantity of the wiring layers. The present invention may be applied to a structure having one wiring layer, or a structure having a plurality of wiring layers having a quantity equal to or more than three.

In addition, in the first through fourth embodiments, the double diffused MOS transistor having the side walls 17 is used as a MOS transistor. However, the present invention is not limited to this MOS transistor, and when a MOS transistor that does not have the side walls 17 or other MOS transistors having different structures is used in the present invention, the same effect and advantage can be obtained.

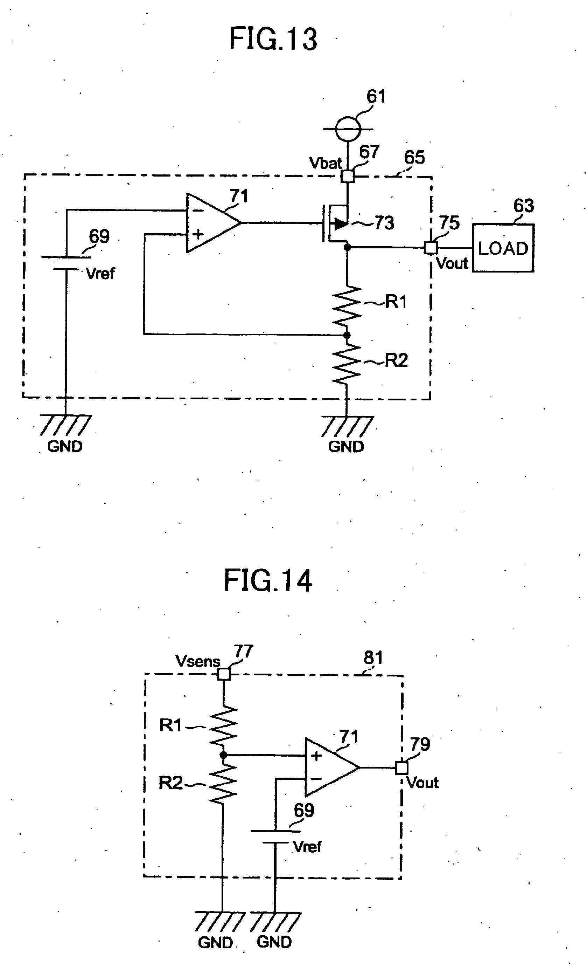

Fig. 13 is a circuit diagram showing one example of a constant voltage generation circuit which is an analog integrated circuit. Any one of the above-described embodiments of the semiconductor device according to the present invention can be applied to this constant voltage generation circuit.

The constant voltage generation circuit 65 is provided for supplying stable electric power to a load 63 from a direct current power supply 61. The constant voltage generation circuit 65 includes an input (Vbat) 67 connected to the DC power supply 61, a reference voltage generation circuit (Vref) 69 as a reference voltage source, and a differential amplifier circuit 71. The constant voltage generation circuit 65 further includes a p-channel MOS transistor (PMOS) 73 constituting an output driver, a voltage divider R1 and R2, and an output (Vout) 75.

An output of the differential amplifier 71 in the constant voltage generation circuit 65 is connected to a gate electrode of the PMOS. A reference voltage Vref from the reference voltage generation circuit 69 is applied to an inverting input of the differential amplifier 71, and a divided voltage that is obtained by dividing an output voltage Vout by the voltage divider R1 and R2 is applied to a non-inverting input of the differential amplifier 71. The divided voltage provided by the voltage divider R1 and R2 is controlled to be equal to the reference voltage Vref.

The polysilicon resistance body constituting any one of the embodiments of the semiconductor device according to the present invention may used as a resistance element constituting the voltage divider R1 and R2. With the polysilicon resistance body which is an element of any one of the embodiments in the present invention, it is possible to improve the resistance value control performance and/or the stabilization of the resistance value. Accordingly, it is possible to improve accuracy in the divided voltage provided from the voltage divider R1 and R2, and therefore, to improve accuracy achieved by the constant voltage generation circuit 65.

Furthermore, the reference voltage generation circuit 69 and the differential amplifier circuit 71 may include the PMOS and the NMOS that constitute any one of the embodiments of the semiconductor device according to the present invention. With the PMOS and the NMOS which constitute any one of the embodiments of the semiconductor device in the present invention, it is possible to improve the threshold voltage control performance and/or the stabilization of the threshold voltage. Accordingly, it is possible to improve accuracy in output provided by the reference voltage generation circuit 69 and the differential amplifier circuit 71, and therefore, to improve accuracy achieved by the constant voltage generation circuit 65.

Fig. 14 shows one example of a voltage detection circuit which is an analog integrated circuit. Any one of the above-described embodiments of the semiconductor device may be applied to this voltage detection circuit.

An inverting input of a differential amplifier circuit 71 is connected to a reference voltage generation circuit 69, and a reference voltage is provided to the inverting input. A voltage at an electric terminal to be measured is input to the voltage detection circuit from an input (Vsens) 77. The input voltage is divided by a voltage divider R1 and R2, and the divided voltage is input to a non-inverting input of the differential amplifier circuit 71. Output provided by the differential amplifier circuit 71 is output to the outside via an output (Vout) 79.

When the voltage at the electric terminal is high, and the divided voltage provided by the voltage divider R1 and R2 is higher than the reference voltage Vref, the differential amplifier circuit 71 maintains high output H. On the other hand, when the voltage at the electric terminal drops, and the divided voltage provided by the voltage divider R1 and R2 becomes equal to or lower than the reference voltage Vref, the output of the differential amplifier circuit 71 becomes low L.

The polysilicon resistance body constituting any one of the above-described embodiments of the semiconductor device may be used as a resistance element constituting the voltage divider R1 and R2 of the voltage detection circuit. With the polysilicon resistance body constituting any one of the embodiments in the present invention, it is possible to improve the resistance value control performance and/or the stabilization of the resistance value. Accordingly, it is possible to improve accuracy in the divided voltage provided by the voltage divider R1 and R2, and therefore, to improve accuracy achieved by the voltage detection circuit 81.

In addition, the reference voltage generation circuit 69 and the differential amplifier circuit 71 of the voltage detection circuit 81 may include the PMOS and the NMOS constituting any one of the above-described embodiments of the semiconductor device according to the present invention. With the PMOS and the NMOS constituting any one of the embodiments in the present invention, it is possible to improve the threshold voltage control performance and/or the stabilization of the threshold voltage. Accordingly, it is possible to improve accuracy in output provided by the reference voltage generation circuit 69 and the differential amplifier circuit 71, and therefore, to improve accuracy achieved by the voltage detection circuit 81.

In the above, the embodiments according to the present invention were described, but the present invention is not limited to these embodiments. Various modifications and other specific forms can be embodied without departing from the scope of the present invention.
The present invention is not limited to the above-described embodiments, and may be embodied in other various specific forms without departing from the scope of the invention.

This patent application is based on Japanese priority patent application No. 2001-347121 filed on November 13, 2001.

## Claims

1. A semiconductor device which includes a polysilicon resistance body (33) and a CMOS device having a p-channel MOS transistor (29, 31) and an n-channel MOS transistor (27),
wherein a silicon nitride film (41) is formed above the n-channel MOS transistor (27) and the polysilicon resistance body (33) and is not formed above the p-channel MOS transistor (29, 31), **characterized in that**
a thermal oxide film (39) having a thickness of 5 to 80 nanometers is directly formed on the n-channel MOS transistor (27) and on the polysilicon resistance body (33), said thermal oxide film (39) being directly formed under the silicon nitride film (41) formed above the n-channel MOS transistor (27) and the polysilicon resistance body (33).

2. The semiconductor device according to claim 1, **characterized in that** a thickness of the silicon nitride film (41) is 5 to 30 nanometers.

3. The semiconductor device according to claim 1 or 2, **characterized in that** the p-channel MOS transistor (29, 31) includes a surface channel type p-channel MOS transistor having a gate electrode (15) which includes a polysilicon film into which p-type impurities have been introduced.

4. The semiconductor device according to any one of claims 1 to 3, **characterized in that** a non-doped oxide film (43) into which impurities have not been introduced is formed on the silicon nitride film (41) above the polysilicon resistance body (33),
an insulation film (45) functioning as insulation between layers is formed on the non-doped oxide film (43),
the polysilicon resistance body (33) is covered with a metal wiring layer (47) such that the insulation film (45) is situated between the polysilicon resistance body (33) and the metal wiring layer (47),
and the metal wiring layer (47) includes metal material containing aluminum, and a thickness of the metal wiring layer (47) is equal to or more than 400 nanometers.

5. The semiconductor device according to claim 4, **characterized in that** another metal wiring layer is not formed above the metal wiring layer (4) which is situated above the polysilicon resistance body (33).

6. The semiconductor device according to any one of claims 1 to 3, **characterized in that** the polysilicon resistance body (33) has a sheet resistance value that is equal to or less than 3000 OMEGA /square,
a non-doped oxide film (43) into which impurities have not been introduced is formed on the silicon nitride film (41) above the polysilicon resistance body (33),
and a metal wiring layer is not formed above the polysilicon resistance body (33).

7. The semiconductor device according to any one of claims 1 to 6, **characterized in that** the thermal oxide film (39) is a dense thermal oxide film which was formed in a dried oxidation atmosphere

## Patentansprüche

1. Halbleitervorrichtung, die einen Polysilicium-Widerstandskörper (33) und eine CMOS-Vorrichtung mit einem p-Kanal-MOS-Transistor (29, 31) und einem n-Kanal-MOS-Transistor (27) enthält,
wobei über dem n-Kanal-MOS-Transistor (27) und dem Polysilicium-Widerstandskörper (33) und nicht über dem p-Kanal-MOS-Transistor (29, 31) eine dünne Siliciumnitrid-Schicht (41) ausgebildet ist, **dadurch gekennzeichnet, dass**
eine dünne thermische Oxidschicht (39) mit einer Dicke im Bereich von 5 bis 80 Nanometer direkt auf dem n-Kanal-MOS-Transistor (27) und auf dem Polysilicium-Widerstandskörper (33) ausgebildet ist, wobei die dünne thermische Oxidschicht (39) direkt unter der dünnen Siliciumnitrid-Schicht (41) ausgebildet ist, die über dem n-Kanal-MOS-Transistor (27) und dem Polysilicium-Widerstandskörper (33) ausgebildet ist.

2. Halbleitervorrichtung nach Anspruch 1, **dadurch gekennzeichnet, dass** die Dicke der dünnen Siliciumnitrid-Schicht (41) im Bereich von 5 bis 30 Nanometern liegt.

3. Halbleitervorrichtung nach Anspruch 1 oder 2, **dadurch gekennzeichnet, dass** der p-Kanal-MOS-Transistor (29, 31) einen p-Kanal-MOS-Transistor des Oberflächenkanaltyps mit einer Gate-Elektrode (15), die eine dünne Polysiliciumschicht enthält, in die p-Störstellen eingeleitet worden sind, umfasst.

4. Halbleitervorrichtung nach einem der Ansprüche 1 bis 3, **dadurch gekennzeichnet, dass** auf der dünnen Siliciumnitrid-Schicht (41) über dem Polysilicium-Widerstandskörper (33) eine dünne nicht dotierte Oxidschicht (43), in die keine Störstellen eingeleitet worden sind, ausgebildet ist,
eine dünne Isolierschicht (45), die als Isolation zwischen Lagen dient, auf der dünnen nicht dotierten Oxidschicht (43) ausgebildet ist,
der Polysilicium-Widerstandskörper (33) mit einer Metallverdrahtungslage (47) bedeckt ist, derart, dass sich die dünne Isolierschicht (45) zwischen dem Polysilicium-Widerstandskörper (33) und der Metallverdrahtungslage (47) befindet,
und die Metallverdrahtungslage (47) Metallmaterial aufweist, das Aluminium enthält, und eine Dicke der Metallverdrahtungslage (47) gleich oder größer als 400 Nanometer ist.

5. Halbleitervorrichtung nach Anspruch 4, **dadurch gekennzeichnet, dass** eine weitere Metallverdrahtungslage nicht über der Metallverdrahtungslage (4), die sich über dem Polysilicium-Widerstandskörper (33) befindet, ausgebildet ist.

6. Halbleitervorrichtung nach einem der Ansprüche 1 bis 3, **dadurch gekennzeichnet, dass** der Polysilicium-Widerstandskörper (33) einen Flächenwiderstandswert hat, der gleich oder kleiner als 3000 Omega/Quadrat ist
die dünne nicht dotierte Oxidschicht (43), in die keine Störstellen eingeleitet worden sind, auf der dünnen Siliciumnitrid-Schicht (41) über dem Polysilicium-Widerstandskörper (33) ausgebildet ist,
und die Metallverdrahtungsschicht nicht über dem Polysilicium-Widerstandskörper (33) ausgebildet ist.

7. Halbleitervorrichtung nach einem der Ansprüche 1 bis 6, **dadurch gekennzeichnet, dass** die dünne thermische Oxidschicht (39) eine dünne, dichte thermische Oxidschicht ist, die in einer trockenen Oxidationsatmosphäre ausgebildet wurde.

## Revendications

1. Dispositif semi-conducteur qui comprend un corps de résistance en polysilicium (33) et un dispositif CMOS possédant un transistor MOS à canal p (29, 31) et un transistor MOS à canal n (27),
dans lequel un film de nitrure de silicium (41) est formée au-dessus du transistor MOS à canal n (27) et du corps de résistance en polysilicium (33) et n'est pas formé au-dessus du transistor MOS à canal p (29, 31), **caractérisé en ce que**
un film d'oxyde thermique (39) possédant une épaisseur de 5 à 80 nm est directement formé sur le transistor MOS à canal n (27) et sur le corps de résistance en polysilicium (33), ledit film d'oxyde thermique (39) étant directement formé sous le film de nitrure de silicium (41) formé au-dessus du transistor MOS à canal n (27) et du corps de résistance en polysilicium (33).

2. Dispositif semi-conducteur selon la revendication 1, **caractérisé en ce qu'**une épaisseur du film de nitrure de silicium (41) est 5 à 30 nm.

3. Dispositif semi-conducteur selon la revendication 1 ou 2, **caractérisé en ce que** le transistor MOS à canal p (29, 31) comprend un transistor MOS à canal p du type à canal de surface possédant une électrode de grille (15) qui comprend un film de polysilicium dans lequel des impuretés de type p ont été introduites.

4. Dispositif semi-conducteur selon l'une quelconque des revendications 1 à 3, **caractérisé en ce qu'**un film d'oxyde non dopé (43) dans lequel des impuretés n'ont pas été introduites est formé sur le film de nitrure de silicium (41) au-dessus du corps de résistance en polysilicium (33),
un film isolant (45) fonctionnant comme isolation entre les couches est formé sur le film d'oxyde non dopé (43),
le corps de résistance en polysilicium (33) est recouvert par une couche de câblage métallique (47) de sorte que le film isolant (45) est situé entre le corps de résistance en polysilicium (33) et la couche de câblage métallique (47),
et la couche de câblage métallique (47) comprend un matériau métallique contenant de l'aluminium, et une épaisseur de la couche de câblage métallique (47) est égale à ou supérieure à 400 nm.

5. Dispositif semi-conducteur selon la revendication 4, **caractérisé en ce qu'**une autre couche de câblage métallique n'est pas formée sur la couche de câblage métallique (4) qui est située au-dessus du corps de résistance en polysilicium (33).

6. Dispositif semi-conducteur selon l'une quelconque des revendications 1 à 3, **caractérisé en ce que** le corps de résistance en polysilicium (33) possède une valeur de résistance de feuille qui est égale à ou inférieure à 3000 OMEGA/carré,
un film d'oxyde non dopé (43) dans lequel des impuretés n'ont pas été introduites est formé sur le film de nitrure de silicium (41) au-dessus du corps de résistance en polysilicium (33),
et une couche de câblage métallique n'est pas formée au-dessus du corps de résistance en polysilicium (33).

7. Dispositif semi-conducteur selon l'une quelconque des revendications 1 à 6, **caractérisé en ce que** le film d'oxyde thermique (39) est un film d'oxyde thermique dense qui a été formé sous atmosphère oxydante sèche.
